# EUROPEAN PATENT APPLICATION

(11) **EP 0 886 322 A2**
(43) Date of publication of application: **23.12.1998**
(21) Application number: 98201873.1
(22) Date of filing: 05.06.1998
(51) Int. Cl.: H01L 31/0203, H01L 31/0232

(54) **Packaging of imaging devices**

(30) Priority: 16.06.1997 US 876453
(71) Applicant: EASTMAN KODAK COMPANY, Rochester, New York 14650 (US)
(72) Inventor: Johnson, Dean A., c/o Eastman Kodak Company, Rochester, New York 14650-2201 (US)
(74) Representative: Parent, Yves

(57) **Abstract**

An image head assembly comprising: a substrate with at least a pair of apertures formed in the substrate; an optical assembly having at least a pair of pins that mate with the apertures within the substrate, the pins to the optical assembly being fixedly secured to the apertures within the substrate; an image sensor located relative to the apertures covered by a cover glass above the image sensor on the optical assembly ; interface means for providing an electrical connection between the substrate and the image sensor; a lens system mounted on top the cover glass; and a single element blur filter contained within the lens system. The assembly contains a single element blur filter such as a cross-pleated blur filter. The lens system is prevented from being a reverse telephoto lens system with use of a blur filter that does not require back focusing and is instead a telephoto lens system.

## Description

The present application is related to U.S. Application Serial Number 08/876,634, filed June 16, 1997, by Peter Zepetella and others., and entitled, "Circuit Board Standoff", U.S. Application Serial Number 08//876,633, filed June 16, 1997 by Bryan Beaman, and others., and entitled "Imager Packaging Substrate.", U.S. Application Serial Number 08/876,456, filed June 16, 1997, by Bryan Beaman and others. and entitled, "Integrated Imaging Head," and U.S. Application Serial Number 08/876,376, filed June 16, 1997 by Dean Johnson and others., and entitled "CCD Attachment Module."

The invention relates generally to the field of packaging for image sensing devices, and in particular to positioning the image sensing device with respect to datum's that can then be used to position the optical elements relative to the image sensing device.

There are numerous prior art devices that have discussed the placement of CCD based image sensors, and solid state devices on the circuit board or carrying package. Co-pending patent application EPO Application No. 96111130.9 filed 11 July 1996 disclosed positioning of an image sensor within a chip carrying package which is located on an assembly, such as a digital camera, using reference features on the chip carrying package to properly mount and align the image sensing device relative to the optical elements.

In a typical imaging application, a solid state image sensing device, in the form of an integrated circuit die (chip), is attached to a cavity in a chip circuit board. The position of the image sensing device is located approximately within an alignment pattern (typically, a cross hair pattern) that is etched in the bottom of the cavity of the chip circuit board. In a typical assembly operation, a video camera is used to find a cut edge of the die as well as the chip carrier alignment pattern. The image sensing device is then centered relative to the alignment pattern and potted in place in the circuit board with glue. The package is usually a laminated ceramic (cerdip), a metal lead frame with ceramic or plastic attached on the top and bottom of the lead frame (plastic dip), or a plastic dual-in-line package. The image sensing device is finally sealed in the chip carrier cavity with a cover glass to protect the image sensing device from contamination.

This entire image sensor (die/carrier) assembly is approximately located in the optical system that is to use it and the image sensing device is then energized. The optical system images one or more imaging targets upon the image sensor assembly, which produces corresponding image signals that are used to precisely position the image sensor assembly in the optimum focus position for the optical system. It is customary for this positioning process to exactly locate the image sensor assembly within the optical system relative to the usual six degrees of positional freedom. This active alignment technique, however, requires extensive fixturing and a significant time to complete. The circuit board may have significant variation, up to +/- 10%, due to the process used to fabricate the circuit boards. In particular, there may be significant variation between the cut edges used in alignment and the optically active pixel sites in the image sensing chips. Moreover, the image sensor assembly process restricts subsequent alignment inspection due to the alignment marks being obscured under the glue used to bond the image sensing device to the circuit board. Inspection with a video camera after assembly for device placement accuracy is therefore difficult or impossible.

Japanese patent publication 63-155648 and 2112280 (1990) suggests use of exact constraints to mechanically locate the cut edges of the image sensing device to features machined in a metal plate that composes the base of the circuit board. An additional locating feature is cut into the edge of the machined metal plate for use as a positioning reference with respect to the optical system in the final product. The patent publication discloses use of the cut edges to locate the image sensing device; however, the aforementioned problem remains, that is, the possibility of significant variation between the cut edges used in alignment and the optically active pixel sites in the image sensing device. Moreover, the locating feature cut into the edge of the machined metal plate neither increases the existing precision nor does it inherently provide exact constraint of the circuit board in the final product.

To simplify production assembly and to allow for image sensor (die/carrier) assembly replacement in the field, it would be desirable to use a passive alignment technique, not requiring video imaging, in which external reference features/datums on the sensor package are used throughout the process, that is, in the sensor assembly process as well as in the final product assembly process. Ideally, the chip circuit board design would specify a standard set of reference features/datums for fabricating and assembling the sensor package, and for positioning the package in the final product.

This present invention simplifies the process of previous devices by removing the imaging device from the carrying package and presenting the bare die, located and bonded to some circuit board, directly onto the optical elements holding device using the exact constraints mounting methods disclosed in the prior art.. The present invention removes the variation of the carrying packages into the product frame.

The most common methods of mounting imagers is to mount the die in a ceramic or plastic Dual in Line Package (DIP) or leadless chip carrier (LCC) package and cover with the package with a glass cover plate. The object is to get the die in a clean, hermetic like environment so that the delicate AC testing of the sensor can proceed. The historical yields at this step provide motivation to keep the value added up to this assembly step to a minimum. It is desirable to look at low cost solutions to enable testing of the imager at the earliest possible opportunity.

The proposal is to use a printed circuit board (PCB - FR4 Material) as the substrate to mount the imager and provide an interface to the test equipment. In addition, the concept includes moving the AC testing earlier in the assembly process before a housing (including a cover glass) are committed to the assembly. Features are included in the substrate and optical housing such that a passive alignment of the assembly is enabled.

The present invention is directed to overcoming one or more of the problems set forth above. Briefly summarized, according to one aspect of the present invention, an image head assembly comprising a substrate with at least a pair of apertures formed in the substrate; an optical assembly having at least a pair of pins that mate with the apertures within the substrate, the pins to the optical assembly being fixedly secured to the apertures within the substrate; an image sensor located between the apertures covered by a cover glass above the image sensor on the optical assembly; interface means for providing an electrical connection between the substrate and the image sensor; a lens system mounted on top the cover glass; and a single element blur filter contained within the lens system. The assembly contains a single element blur filter such as a cross-pleated blur filter. The lens system is prevented from being a reverse telephoto lens system with use of a blur filter that does not require back focusing and is instead a telephoto lens system.

These and other aspects, objects, features, and advantages of the present invention will be more clearly understood and appreciated from a review of the following detailed description of the preferred embodiments and appended claims, and by reference to the accompanying drawings.

The present invention has the advantage in satisfying the need for active alignment of the image sensing device at a lower cost, yielding a higher volume potential, with fewer interfaces and less tolerance accumulation.
Fig. 1 - substrate details showing alignment features and test pads.
Fig. 2 - alignment features of the optics assembly.
Fig. 3 - alignment of the die to the substrate
Fig. 4 - alignment of the optics assembly to the substrate

To facilitate understanding, identical reference numerals have been used, where possible, to designate identical elements that are common to the figures.

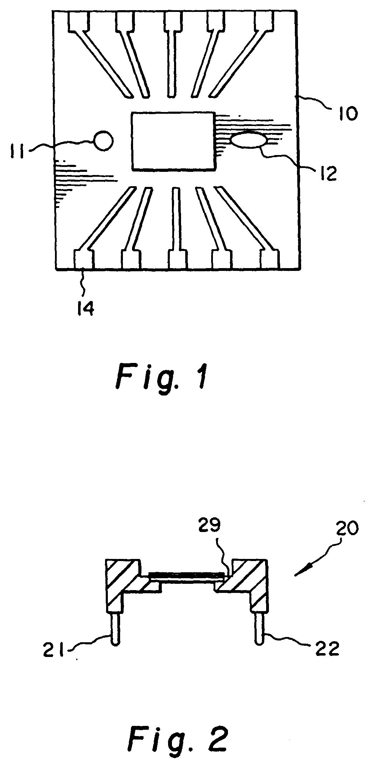

Referring to Fig. 1 illustrates details of the printed circuit substrate 10 showing alignment features within the substrate 10 comprising a pair of apertures 11, 12 formed within the substrate 10. There are a plurality of test pads 14 provided that are to be wire bonded to a solid state image sensor.

Fig. 2 illustrates an optical assembly 20 and the alignment features of the optics assembly 20. The optical assembly 20 has within the preferred embodiment a pair of pins 21, 22. These pins 21, 22 shown in Fig. 2 mate with the apertures 11, 12 within the substrate 10 shown in Fig. 1. In Fig. 2, lens 25 rests within shelf 29.

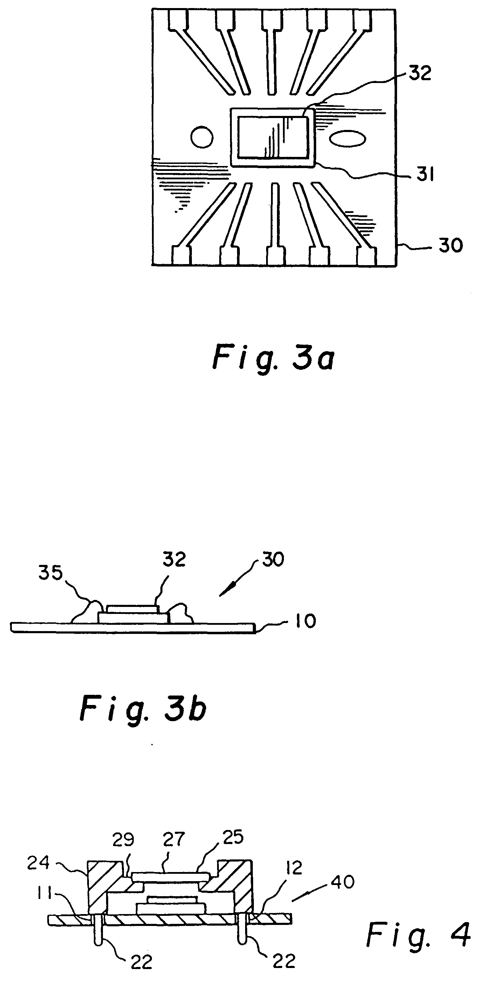

Fig. 3 illustrates the alignment of a solid state image sensor 32 to the substrate 10. The image sensor 32 is located in an area formed between apertures 11, 12, and is mounted directly to the substrate 10. The interface for providing an electrical connection between the substrate 10 and image sensor 32 is envisioned to be wire bonding (not shown) that will connect leads on the image sensor to the test pads 14 on substrate 10. In the preferred embodiment, the image sensor 32 is placed within a location area 31 and a silver filled epoxy is within the image sensor location area 31. The image sensor 32 is attached to the substrate 10 via the silver filled epoxy.

Still referring to Fig. 3, the image sensor assembly 30 is used for mounting the optical system 20 discussed if Fig. 2. The image sensor 32 has photolithographically generated elements that can be illuminated during the assembly process. This allows for the solid state image sensor 32 to be mounted directly on the circuit board substrate 10. The substrate 10 has externally accessible reference features, apertures 11, 12 that allow at least one of the photolithographically generated elements on the image sensor to be used to align the image sensor 32 to the circuit board 10. The image sensor assembly 30 allows the externally accessible apertures 11, 12 to be used by conventional machine vision alignment equipment to create at least two virtual straight edges that are orthogonal to one another and align the circuit board substrate to the photolithographically generated elements on the image sensor 32. The photolithographically generated elements are image sensing sites on image sensor 32 may conceivably be image sensing sites such as photodetectors or the photolithographically generated elements may be bonding pads. It is also envisioned the photolithographically generated elements could be dedicated registration marks.
The image sensor 32 is electrically connected, to electrical conductors 14 on substrate 10 via wirebonding 35.

The image sensor assembly 30 therefore, includes an image sensing device placed upon a circuit board, the circuit board being exactly constrained with reference to a set of reference features on the circuit board.

Fig. 4 illustrates the alignment of the optics assembly 20 to the substrate 10 to create assembly 40. The assembly 40 has the optical assembly 20 mounted within its housing 24 that contains pins 21, 22 that are keyed to fit within apertures 11, 12. The lens 25 serves as a cover glass and is contained on the housing 24. An IR filter is placed in the optical assembly 40 housing 24 by placing the IR filter 27 on lens 25. The assembly has a shelf 29 that is used to align cover glasses and IR filters 27.

Still referring to Fig. 4, the system 40 comprises a lens 25 for focusing an image upon the image sensor 32 within an image plane; a plurality of reference locators that are positioned relative to the lens 25 to provide a reference for locating the imaging plane; a circuit board substrate 10 adapted for exact constraint of the image sensor 32 to at least a pair of fiducial marks on the substrate 10, which in the preferred embodiment are apertures 11, 12; and means for holding the circuit board substrate 10 in place against the plurality of locators in order to exactly constrain the circuit board substrate 10 within the optical system. The assembly 40 provides an aligned optical assembly 20 used in conjunction with circuit assembly 30 so that the optics is aligned with the image sensor 32.

### PARTS LIST

- 10: substrate
- 11: aperture
- 12: aperture
- 14: electrical conductor
- 20: optical assembly
- 21: pin
- 22: pin
- 24: housing
- 25: lens
- 27: IR filter
- 29: shelf
- 30: die on the substrate
- 31: location area
- 32: image sensor
- 35: wire bonding
- 40: optics assembly

## Claims

1. An image sensor assembly for mounting in an optical system, the image sensor assembly having photolithographically generated elements comprising:
a solid state image sensing device mounted directed on a circuit board substrate, the circuit board functioning as a substrate for the image sensor, the substrate having externally accessible reference features that are aligned with respect to at least one of the photolithographically generated elements on the image sensor.

2. An image sensor assembly as claimed in claim 1 wherein the externally accessible reference features include at least two straight edges that are orthogonal to one another and used in aligning the circuit board to the photolithographically generated elements.

3. An image sensor assembly as claimed in claim 1 wherein the photolithographically generated elements are image sensing sites.

4. An image sensor assembly as claimed in claim 1 wherein the photolithographically generated elements are bonding pads.

5. An image sensor assembly as claimed in claim 1 wherein the photolithographically generated elements are dedicated registration marks.

6. An image sensor assembly for mounting in an optical system having a plurality of reference locators, the image sensor assembly comprising:
an image sensing device; and
a circuit board adapted for exact constraint to a set of features on the circuit board that are externally accessible to the reference locators, wherein the set of features comprises two openings extending into the circuit board to provide an inset surface that provides two targets to set the plane of the circuit board against the reference locators, and wherein two of the openings are squared in order to provide two straight edges that are urged against at least one of the reference locators to set the remaining degrees of freedom.

7. A method for assembling an image sensing device in a circuit board, the method including the steps of:
providing externally accessible reference features on the circuit board; and
referencing the position of photolithographically generated elements on the image sensing device to the externally accessible reference features on the circuit board.

8. A method as claimed in claim 7 further including the step of determining the location of the photolithographically generated elements with a video system.

9. A method for assembling an image sensing device on a circuit board substrate into an optical system defined by the steps of:
providing a plurality of externally accessible reference features on the circuit board;
referencing photolithographically generated elements on the image sensing device to the externally accessible reference features on the circuit board; and
using the externally accessible reference features to position the circuit board in the optical system.

10. A method as claimed in claim 9 further including the step of determining the location of the photolithographically generated elements with a video system.
